# EUROPÄISCHE PATENTSCHRIFT

(11) **EP 2 129 815 B1**
(45) Veröffentlichungstag und Bekanntmachung des Hinweises auf die Patenterteilung: **13.05.2020**
(21) Anmeldenummer: 07856920.9
(22) Anmeldetag: 19.12.2007
(51) Int. Cl.: C30B 25/00, C30B 25/02, C30B 25/14, C30B 29/40

(54) **VERFAHREN ZUM HERSTELLEN EINES VERBINDUNGSHALBLEITERMATERIALS MITTELS GASPHASENEPITAXIE**
METHOD FOR THE PRODUCTION OF A COMPOUND SEMICONDUCTOR MATERIAL BY MEANS OF GAS PHASE EPITAXY
PROCÉDÉ POUR PRODUIRE UN MATÉRIAU SEMICONDUCTEUR DE LIAISON PAR ÉPITAXIE EN PHASE GAZEUSE

(30) Priorität: 02.03.2007 DE 102007010286
(43) Veröffentlichungstag der Anmeldung: 09.12.2009
(73) Patentinhaber: Freiberger Compound Materials GmbH, 09599 Freiberg (DE)
(72) Erfinder: LEIBIGER, Gunnar, 09599 Freiberg (DE); HABEL, Frank, 09599 Freiberg (DE); EICHLER, Stefan, 01187 Dresden (DE)
(74) Vertreter: Prüfer & Partner mbB Patentanwälte · Rechtsanwälte
(86) Internationale Anmeldenummer: PCT/EP2007/011197
(87) Internationale Veröffentlichungsnummer: WO 2008/107010

(56) Entgegenhaltungen:
- WO-A-01/14619
- US-A1- 2005 009 221
- US-A1- 2006 011 135
- DAM ET AL: "Carrier gas and position effects on GaN growth in a horizontal HVPE reactor: An experimental and numerical study" JOURNAL OF CRYSTAL GROWTH, ELSEVIER, AMSTERDAM, NL, Bd. 285, Nr. 1-2, 15. November 2005 (2005-11-15), Seiten 31-40, XP005123685 ISSN: 0022-0248

## Beschreibung

Die vorliegende Erfindung bezieht sich auf ein Verfahren zur Herstellung von Verbindungshalbleiterwerkstoffen aus der Gasphase, insbesondere von III-N-Schichten oder III-N-Bulkkristallen sowie von freistehenden III-N-Substraten, die aus den III-N-Bulkkristallen gewonnenen werden.

Sie bezieht sich ferner auf besondere Eigenschaften aufweisende III-N-Bulkkristalle oder freistehende III-N-Substrate.

Bekannte Verbindungshalbleiterwerkstoffe sind beispielsweise Kombinationen von Elementen der III. und V. Hauptgruppe des Periodensystems. Ein wichtiger Vertreter ist Galliumarsenid (GaAs), das als Grundmaterial in der Hochfrequenztechnik oder der Optoelektronik dient. Gerade im Bereich der Herstellung optoelektronischer Bauelelemente, etwa der blauen LEDs (light e-mitting diodes), haben in den vergangenen Jahren jedoch auch die Nitride dieser Verbindungshalbleiter besondere Aufmerksamkeit erlangt, insbesondere Galliumnitrid (GaN).

Die Nitride der Verbindungshalbleiterwerkstoffe werden als III-N-Materialien bezeichnet. Dabei bedeutet "III" mindestens ein Element der III. Hauptgruppe des Periodensystems, ausgewählt aus Aluminium, Gallium und Indium (im folgenden auch abgekürzt mit Al, Ga oder In), und "N" steht für das Element Stickstoff der V. Hauptgruppe. Diese Materialien können als freistehende III-N-Substrate gefertigt werden, die dann als Basissubstrate zur Fertigung von opto- und mikroelektronischen Bauelementen sehr gut geeignet sind.

Herkömmlich sind in der gewerblichen Anwendung Bauelemente für (Al,Ga,In)N-basierende Leucht- oder Laserdioden im wesentlichen auf Fremdsubstraten wie Al₂O₃ (Saphir) oder SiC (Siliziumcarbid) gezüchtet worden.

Durch die Verwendung der Fremdsubstrate entstehen allerdings Nachteile hinsichtlich der Kristallqualität. Die Kristallgitter passen nämlich nicht gut zueinander. Die Folge ist jedenfalls eine Einbuße an Bauelementelebensdauer und -effizienz.

Ein Ausweg stellt das Wachstum auf freistehenden III-N-Substraten, wie z.B. (Al,Ga,In)N-Substraten dar. Letztere sind jedoch in ausreichender Qualität bisher kaum verfügbar. Die Ursache dafür sind im wesentlichen Schwierigkeiten bei konventionellen Bulkzüchtungstechnologien aus einer Schmelze auf Grund des extrem hohen Gleichgewichtsdampfdrucks von Stickstoff über III-N-Verbindungen bei typischen Wachstumstemperaturen. Selbst beim Ziehen von Indiumphosphid (InP) liegt bei entsprechenden Temperaturen bereits ein Druck von 30 bar vor. Der Druck von Stickstoff würde noch um Größenordnungen darüber liegen.

Eine derzeit kommerziell genutzte Möglichkeit zur Züchtung von (Al,Ga,In)N-Substraten ist die Hydridgasphasenepitaxie (HVPE). Das Verfahren wurde bereits 1969 von H.P. Maruska and J.J. Tietjen (Applied Physics Letters 15 (1969) S. 327-329) beschrieben. Mit diesem Verfahren wird eine Kristallzüchtung aus metallisch vorliegenden Quellen der Elemente aus der III. Hauptgruppe und Wasserstoffverbindungen der Elemente der V. Hauptgruppe vorgenommen.

Andere relevante Verfahren zum Herstellen eines Verbindungs-Halbleiterwekstoffs mittels Gasphasenepitaxie sind auch aus US 2005/009221 A1, US 2006/011135 A1 und WO 01/14619 A bekannt.
Zur Herstellung von Galliumnitrid wird beispielsweise Gallium bei hohen Temperaturen von 800-900 °C Chlorwasserstoff (HCl) ausgesetzt. Dies reagiert zu Galliumchlorid und trifft im HVPE-Reaktor bei noch höheren Wachstumstemperaturen von etwa 1000-1100 °C in der Umgebung des Substrats auf Ammoniak (NH₃). Aus einer entsprechenden Reaktion heraus wird Galliumnitrid (GaN) auf das Substrat abgeschieden. Eine Besonderheit des HVPE-Verfahrens sind die hohen Wachstumsraten von 50 - 250 µm pro Stunde bei vergleichsweise guter Kristallinität.

Für die Bildung dünner Schichten mit hoch präziser Schichtdickenhomogenität herrscht zumindest derzeit allerdings noch die metallorganische Gasphasenepitaxie (MOVPE) vor.

Für das HVPE-Verfahren stehen im wesentlichen zwei Varianten zur Züchtung von (Al,Ga,In)N-Substraten zur Verfügung:
a) die epitaktische Züchtung von III-N-Material auf Fremdsubstrat aus der Gasphase mit anschließender Abtrennung vom Fremdsubstrat, und
b) die Züchtung von dicken III-N-Bulkkristallen (sogenannten Boules) auf einem III-N-Substrat mittels Gasphasenepitaxie bei anschließender Vereinzelung des Bulkkristalls, beispielsweise durch ein Sägeverfahren.

Zur Variante a) stellt sich zunächst das Problem, wie eine Trennung des gezüchteten Materials vom Fremdsubstrat bewerkstelligt wird. M. Kelly et al. (Jpn. J. Appl. Phys. Vol 38, 1999, S. L217-L219) schlagen vor, eine auf einem Substrat aus Saphir (Al₂O₃) mittels Hydridgasphasenepitaxie (HVPE) gewachsene dicke GaN-Schicht von dem Saphirsubstrat abzulösen. Die mit GaN beschichteten Saphirsubstrate werden dazu mit einem Laser bestrahlt. Die GaN-Schicht an der Grenzfläche zum Saphirsubstrat wird infolge dessen lokal thermisch zersetzt und löst sich von dem Saphirsubstrat ab.

Alternativ kann auch ein nasschemisches Ätzen (etwa bei GaAs: K. Motoki et al., Jap. J. Appl. Phys. Vol. 40, 2001, S. L140-L143), ein trockenchemisches Ätzen (etwa bei SiC; Melnik et al., Mat. Res. Soc. Symp. Proc. Vol. 482, 1998, S. 269-274) oder ein mechanisches Abläppen (etwa bei Saphir; H.-M. Kim et al., Mat. Res. Soc. Symp. Proc. Vol. 639, 2001, S. G6.51.1-G6.51.6) des Substrates vorgesehen sein.

Zur Variante b) wurde von Vaudo et al. in US 6,596,079 A eine Züchtungsmethode von Kristallboules mit Längen von mehr 1, 4 oder 10 mm gemäß HVPE vorgeschlagen. Durch Drahtsägen und weitere Bearbeitungsschritte, darunter chemisch-mechanisches Polieren, reaktives Ionenstrahlätzen oder photoelektrochemisches Ätzen, werden III-N-Substrate aus dem Bulkkristall erhalten. In WO 01/68955 A1 beschreiben Vaudo et al. darüber hinaus auch mittels der beschriebenen Technologie produzierte III-N-Bulkkristalle und III-N-Substrate.

Um die Reaktionsgase in der Reaktorkammer zum Substrat zu führen, werden sog. Trägergase verwendet. Sie sind im wesentlichen chemisch neutral, dienen der Einstellung eines gewünschten Strömungsprofils, um die Reaktionsgase auf das Substrat lokalisieren zu können und schützen die Reaktionsgase vor einer vorzeitigen Reaktion mit der Folge parasitärer Abscheidung and der Reaktorwand oder an inneren Bauteilen der Reaktionskammer.

Als Trägergase sind beispielsweise Stickstoff, Wasserstoff (Maruska et al. und Motoki et al.; Referenzen vgl. oben) oder alternativ Argon (Melnik et al.) bekannt. Es ist auch bekannt, Trägergase zu mischen. So wird vorgeschlagen, Wasserstoff und Stickstoff als Trägergase in einem vorab experimentell bestimmten Verhältnis zu mischen, um die erhaltene Kristallqualität zu verbessern (C. Dam et al., J. Cryst. Growth 285 (2005) S. 31-40 und F. Habel, Annual Report 2003, Optoelectronics Department, Universität Ulm, S. 77-80).

Andererseits gibt es aber auch das Problem, dass sich durch eine Variation des Mischungsverhältnisses von Wasserstoff etwa zu Stickstoff auch die Strömungsverhältnisse in der Reaktorkammer und damit die Homogenität der Wachstumsratenverteilung über das Substrat hinweg verändern kann (C. Dam et al. und M. Meyyappan et al., J. Vac. Sci. Technol. A16 (1998), S. 685-688). Es wird daher schwierig, gleichzeitig die stabile Strömung der Gase in der Reaktorkammer und die Effizienz der Reaktion steuern zu können.

Der vorliegenden Erfindung liegt daher die Aufgabe zugrunde, ein Verfahren bereitzustellen, mit der die Kristallinität und die Homogenität des zu erhaltenden Kristalls weiter verbessert werden kann.

Die Aufgabe wird gelöst durch ein Verfahren mit den Merkmalen des Anspruchs 1 und durch die erhaltenen III-N-Kristalle nach Anspruch 6.

Der Erfindung zufolge werden Verbindungshalbleiterwerkstoffe - dotiert oder undotiert, halbleitend oder halbisolierend - hergestellt. Insbesondere werden III-V-Kristalle hergestellt. Bevorzugt wird das Verfahren zur Bildung von III-N-Kristallen eingesetzt. Besondere Vorteile ergeben sich im Fall von Galliumnitrid-(GaN)-kristallen. Andere von den angegebenen Oberbegriffen umfasste spezielle Verbindungen sind von der Erfindung eingeschlossen.

Einem ersten Aspekt der Erfindung zufolge wird ein Verbindungs-Halbleiterwerkstoff mittels Gasphasenepitaxie in einem Reaktor hergestellt, bei dem in einem Gemisch von Trägergasen ein durch lokale Massenflussraten repräsentiertes Strömungsprofil in dem Reaktor ausgebildet wird, wobei das Gemisch ein oder mehrere Reaktionsgase in Richtung auf ein Substrat mitführen kann. Es wird dabei eine für die Reaktion und Abscheidung der Reaktionsgase wichtige Konzentration von Wasserstoff an der Oberfläche des Substrats unabhängig von dem im Reaktor ausgebildeten Strömungsprofil eingestellt.

Indem die Konzentration von Wasserstoff unabhängig vom Strömungsprofil eingestellt wird, kann für eine vorgegebene Konzentration ein beliebiges Strömungsprofil realisiert werden. Eine freie Einstellbarkeit des Strömungsprofils erlaubt es wiederum, das anteilige Strömungsprofil der zum Substrat zugeführten Reaktionsgase in beliebiger Weise anzupassen.

Während also über die Wasserstoffkonzentration an der Oberfläche des Substrats die Kristallinität des gezüchteten Materials optimiert wird, stellt sich durch eine Steuerung des Strömungsprofils eine gewünschte Schichtdickenhomogenität ein. Beides kann mit der Erfindung weitgehend unabhängig voneinander gehandhabt werden.

Die Einstellung der Wasserstoffkonzentration kann beispielsweise erfolgen, indem Wasserstoff und Stickstoff als Trägergase eingesetzt werden. Mit dem Wasserstoffanteil bzw. dem Verhältnis von Wasserstoff zu Stickstoff wird unmittelbar die Konzentration von Wasserstoff an der Kristalloberfläche beeinflusst.

Mit Stickstoff und einem weiteren Trägergas, z.B. Argon, das ein von Stickstoff verschiedenes Trägergasgewicht aufweist, kann das Strömungsprofil beeinflusst werden, und zwar derart, dass der unausweichliche Einfluss Wasserstoffanteils in dem Trägergasgemisch auch auf das Strömungsprofil gerade wieder kompensiert wird.

Das Strömungsprofil hängt einerseits von den Abmessungen und der Form des Reaktorinnenraums ab, der zylindrisch sein kann.

Andererseits besitzt der Reaktor beispielsweise konzentrische ringförmige Gaseinlässe zur Ausbildung von Träger- und Reaktionsgaslinien im laminaren Strom. Besitzen die über die Gaseinlässe bei den jeweiligen Radiuspositionen eingeleiteten Gaslinien eine voneinander unterschiedliche Dichte, so hat dies Einfluss auf das Strömungsprofil, das durch lokale Massenflussraten (Impulsflüsse) bestimmt ist.

Durch Einstellen der Volumenstromanteile über z.B. ein von der Position der betrachteten Trägergaslinie abhängiges Mischungsverhältnis der beiden weiteren Trägergase kann das gewünschte Strömungsprofil eingestellt werden. Es wurde herausgefunden, dass der Volumenstromanteil von Wasserstoff nun nicht mehr an einem festen Mischungsverhältnis zu Stickstoff festgemacht werden muss. Vielmehr ist der Volumenstromanteil davon abgekoppelt. Ein Weniger an Wasserstoff (um etwa die H₂-Konzentration zu verringern) kann durch ein Mehr im Mischungsverhältnis des schwereren Trägergases (z.B. Argon) relativ zum leichteren (z.B. Stickstoff) ausgeglichen werden. Dadurch bleibt die lokale Massenflussrate und somit das Strömungsprofil erhalten.

Anders herum kann auch die Massenflussrate durch Anpassung des Mischungsverhältnisses der beiden schwereren Trägergase erhöht werden, etwa um eine Wachstumsratenverteilung auf dem Substrat zu ändern. Die Wasserstoffkonzentration an der Substratoberfläche kann dabei konstant gehalten werden.

Einem weiteren Aspekt der Offenbarung zufolge wird ein Gasphasenepitaxieverfahren in einem Reaktor durchgeführt, der eine Anzahl von jeweils Trägergase und teilweise Reaktionsgase einleitenden Gaslinien aufweist. In zumindest einer der Gaslinien des Reaktors wird simultan - vorzugsweise während der Wachstumsphase - ein chemisch inertes Trägergas, Wasserstoff sowie Stickstoff eingeleitet.

Das erste, chemisch inerte Trägergas kann Argon sein. Andere Trägergase, insbesondere Edelgase wie Helium etc. kommen ebenfalls in Betracht.

Gemäß dem erfindungsgemäßen Verfahren kann der herzustellende Verbindungs-Halbleiterwerkstoff ein III-N-Kristall, insbesondere eine III-N-Schicht auf Fremdsubstrat oder ein III-N-Bulksubstrat sein.

Der herzustellende III-N-Kristall kann Galliumnitrid umfassen, wobei das Galliumnitrid aufgrund einer Reaktion der eingeleiteten Reaktionsgase mit anschließender Abscheidung auf dem Substrat im Reaktor monokristallin gebildet werden kann.

Als Substrat kommt beispielsweise in Betracht: Saphir, Silizium, Siliziumcarbide, Diamant, Lithiumgallate, Lithiumaluminate, Zinkoxide, Spinelle, Magnesiumoxide, ScAlMgO₄, GaAs, GaN, AlN, InN, AlGaN oder InGaN.

Weitere Aspekte, Vorteile und Ausbildungen sind den beigefügten Ansprüchen zu entnehmen.

Die Erfindung soll nun anhand von Ausführungsbeispielen mit Hilfe einer Zeichnung näher erläutert werden. Darin zeigen:
- Figur 1:: in schematischer Darstellung den Aufbau einer horizontalen HVPE-Anlage, in welcher die Erfindung gemäß einem ersten Ausführungsbeispiel ausgeführt wird;
- Figur 2:: wie Figur 1, jedoch eine vertikale HVPE-Anlage betreffend, in welcher die Erfindung gemäß einem zweiten Ausführungsbeispiel ausgeführt wird;
- Figur 3:: wie Figur 2, jedoch im Querschnitt, zur Darstellung der konzentrische Ringe für die den einzelnen Gaslinien entsprechenden Gaseinlässe;
- Figur 4:: einen beispielhaften Ablauf des erfindungsgemäßen Verfahrens.

In den Ausführungsbeispielen wird eine HVPE-Anlage derart umgebaut, dass mindestens in einer der Trägergaslinien ein Gemisch aus Wasserstoff, Stickstoff und Argon mit jeweiligen Volumenstromanteilen von 0 % bis 100 % eingestellt werden kann.

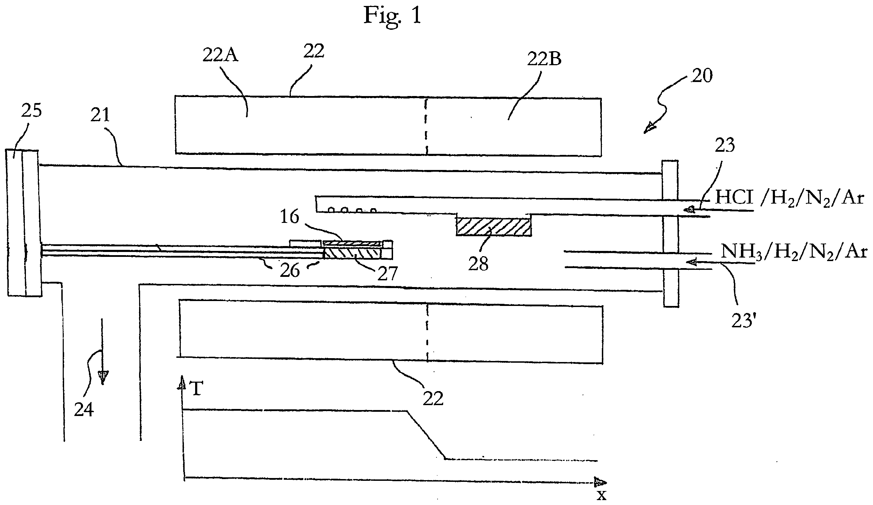

Fig. 1 zeigt in schematischer Darstellung ein Beispiel für einen grundsätzlichen Aufbau einer HVPE-Anlage im Querschnitt, auf die die vorliegende Erfindung anwendbar ist. Vorliegend soll darin eine GaN-Schicht auf ein Template, z.B. ein Fremdsubstrat oder ein GaN-Substrat, abgeschieden werden.

Vor dem Wachstum wird das Start- oder Keimsubstrat 16 bereitgestellt. Das GaN-Substrat besitzt z.B. einen Durchmesser von mehr als 5 cm bei einer (0001) Orientierung bzw. einer leichten Verkippung der Substratoberfläche gegen die exakte (0001) Ebene.

Die HVPE-Anlage 20 gemäß einer möglichen Ausführungsform schließt einen horizontalen Glasreaktor 21, einen diesen umgebenden Mehrzonenofen 22, durch Pfeile angedeutete Gaseinlässe 23, 23' und ein durch einen Pfeil angedeutetes Pump- und Abgasystem 24 ein.

Das GaN-Substrat 16 wird auf einem Substrathalter 26 durch den Ent- und Beladeflansch 25 in den Reaktor 21 eingebracht. Mit dem Pump- und Abgassystem 24 wird der Reaktor danach auf den gewünschten Prozessdruck gebracht, geeigneter Weise im Bereich von ≤ 1000mbar, zum Beispiel bei etwa 950 mbar.

Der Mehrzonenofen besitzt eine erste Zone 22A, mit der die Wachstumstemperatur auf der Oberfläche des Substrats festgelegt wird und eine zweite Zone 22B, mit der die Temperatur im Bereich einer Ga-Wanne 28 festgelegt wird. Über die Gaseinlässe 23, 23' werden Ar, H₂ und N₂ als Trägergase in den Reaktor eingelassen. Durch die Gaseinlässe 23, 23' wird hier jeweils eine (Träger-)gaslinie definiert.

Zur *in situ* Erzeugung von Galliumchlorid wird das in der Ga-Wanne vorliegende Gallium (Ga) durch Einstellen einer geeigneten Temperatur in der Zone 22B des Mehrzonenofens 22, z.B. auf etwa 850°C, erhitzt und mit Chlorwasserstoff (HCl), das aus der Gasversorgung 23 mit Ar/H₂/N₂-Trägergas in passendem Gasmischungsverhältnis und mit geeigneter Strömungsrate eingeströmt wird, umgesetzt.

Das *in situ* erzeugte Galliumchlorid (GaCl) strömt aus den in Fig. 1 angedeuteten Öffnungen am Ende des Einströmrohrs 23 in den Reaktor 21, wird dort mit Ammoniak (NH₃), das aus dem Gaseinlass 23' mit einem der beiden Ar/H₂/N₂-Trägergasgemische in passendem Gasmischungsverhältnis und mit geeigneter Strömungsrate zum Einstellen eines gewünschten NH₃-Partialdrucks von z.B. etwa 6 bis 7 10³ Pa eingeleitet wird, vermischt.

Es findet eine chemische Reaktion von Galliumchlorid mit Ammoniak (NH₃) zu Galliumnitrid (GaN) statt. Ferner entstehen wieder Chlorwasserstoff (HCl) sowie Wasserstoff (H₂) als Nebenprodukte, die mit den anderen Trägergasen zusammen das System wieder über das Pump- und Abgassystem 24 verlassen.

An der Oberfläche des Substrats 16 trägt der gebildete Wasserstoff zusammen mit dem als Trägergas zugeleiteten Wasserstoff zu einer lokalen Wasserstoffkonzentration bei. Diese kann das lokale Reaktionsverhalten nachhaltig beeinflussen, denn es erhöht beispielsweise die Oberflächenbeweglichkeit der Spezies. Infolgedessen wird in diesem Ausführungsbeispiel der Volumenstrom des in den beiden Gaslinien eingeleiteten Wasserstoffs auf einen optimalen Wert eingestellt, der experimentell bestimmt wurde. Die Bestimmung erfolgte beispielsweise durch eine Untersuchung der Oberflächenmorphologie in Habel (s.o.). Der zum Erreichen der Zielkonzentration von Wasserstoff bestimmte Wert des Volumenstromanteils muss in der Regel für jeden Reaktor neu untersucht werden.

Die lokale Wasserstoffkonzentration wird überwiegend durch das zugeflossene Trägergas und nur zu einem geringen Teil durch Wasserstoff als Nebenprodukt der Reaktion bestimmt.

Der Volumenstrom der jeweiligen Gaslinien kann dabei unterschiedlich sein. Dies hängt auch vom Strömungsprofil in dem Reaktor 20 ab. Ist er unterschiedlich, oder sind die Massenflussraten der beiden Gaslinien nicht aufeinander abgestimmt, so werden die Mischungsverhältnisse der beiden anderen Trägergase Ar und N₂ zueinander jeweils für die den Gaseinlässen 23, 23' zugeordneten Trägergaslinien individuell angepasst. Die Mischungsverhältnisse können insbesondere unterschiedlich sein, und zwar derart, dass die durch die Anpassung des Volumenstroms von H₂ hervorgerufene Änderung im Strömungsprofil gerade ausgeglichen wird.

Wie am Temperaturprofil in Fig. 1 unten erkennbar ist, wird in der Zone 22A des Mehrzonenofens 22 eine relativ zur Zone 22B höhere Temperatur zur Einstellung einer Substrattemperatur von geeigneter Weise etwa 950-1100°C, z.B. um 1050°C, eingestellt. Auf dem Substrathalter wird in diesem Beispiel GaN abgeschieden.

Falls anstelle einer GaN-Schicht z.B. eine (Ga,Al,In)N-, (Ga,Al)N- oder (Ga,In)N-Schicht abgeschieden werden soll, ist/sind in der HVPE-Anlage 20 zusätzliche Al- und/oder In-Wannen vorgesehen. Die Einströmung von entsprechendem Aluminium- und/oder Indiumchlorid in den Reaktor erfolgt dann durch Zustrom von HCl in geeignetem Trägergas von z.B. H₂/N₂, analog wie in Fig. 1 mit dem Gaseinlass 23 für Ga gezeigt.

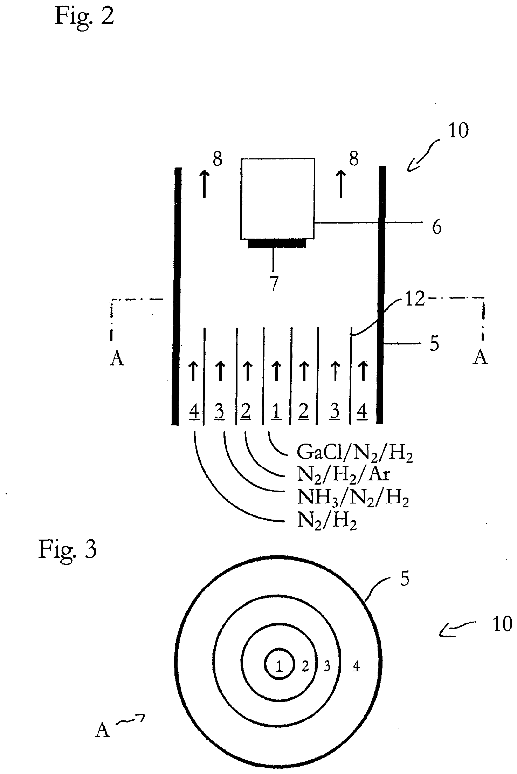

Die Figuren 2 und 3 zeigen in schematischer Darstellung ein zweites Ausführungsbeispiel eines mit der Erfindung einsetzbaren vertikalen Reaktors 10 im Querschnitt. Es handelt sich beispielsweise um einen vertikalen Aixtron HVPE-Reaktor. Wie im vorigen Ausführungsbeispiel wird eine kristalline Schicht aus GaN aufgebaut, hier beispielsweise auf einem Fremdsubstrat aus Saphir (Template 7).

Der vertikale Reaktor 10 besitzt konzentrische Gaseinlässe 1-4, die durch zylinderförmige Trennwände 12 aus Quarzglas voneinander abgeteilt sind. Im Gaseinlass 1 in der Mitte wird Galliumchlorid (GaCl) eingeleitet. Der sich in Richtung nach außen daran anschließende Gaseinlass 2 repräsentiert eine Separationslinie. Es folgt der Gaseinlass 3 für Ammoniak und schließlich der Gaseinlass 4 für die Wandspüllinie an der Reaktorau-ßenwand 5.

Diese konzentrischen Schalen enden etwa 10 cm vor dem Substrat bzw. Template 7. Ab hier mischen sich die Gase in kontrollierter Weise. Das Template 7 liegt auf einer Halterung 6 mit Suszeptor aus Graphit auf. Nachdem die Gase das Template passiert haben, verlassen sie das System durch den Gasauslass 8.

Die Separationslinie zum Gaseinlass 2 hat den Zweck, unmittelbar am Ende des Einlasses das Zusammentreffen von Ammoniak und Galliumchlorid und damit das parasitäre Abscheiden von Galliumnitrid zu verhindern. Gleiches gilt für die dem Gaseinlass 4 zugeordnete Wandspüllinie, welche die Reaktoraußenwand 5 vor parasitärer Abscheidung schützt.

Gemäß dem Ausführungsbeispiel wird das Gasmischsystem verändert ausgeführt: In die Gaszuführung (nicht dargestellt) zur Separationslinie münden drei Gasleitungen: eine für Ar, eine für H₂, und eine für N₂. Die Zusammensetzung des Gemischs bzw. der jeweilige Volumenstrom kann durch Massenflussregler individuell eingestellt werden.

Der Prozess der Kristallzüchtung ist nun wie folgt: es kann optional zunächst ein thermischer Ausheilschritt bei einer mittleren oder bei der Wachstumstemperatur sowie in einer Gasatmosphäre bestehend aus einem oder mehreren der Gase Wasserstoff, Stickstoff, Argon oder Ammoniak, mindestens jedoch aus Ammoniak erfolgen.

Nach Erreichen der Wachstumstemperatur wird das III-N-Kristallwachstum (d.h., von GaN) durch Zuschaltung des Gruppe-III-Quellenmaterials (d.h., Ga) gestartet. Das bedeutet beispielsweise im Fall des GaN-Bulkkristallwachstums, das Chlorwasserstoffgas über die Gallium-Quelle geleitet wird, wodurch Galliumchloridgas entsteht, wie beim ersten Ausführungsbeispiel.

Vor dem Starten des III-N-Kristallwachstums wird in den Trägergaslinien noch die geeignete Zusammensetzung aus Wasserstoff, Stickstoff und Argon eingestellt. Dieser Schritt dauert in der Regel so lang, bis sich stabile Gasflüsse gebildet haben. Die entsprechenden Zusammensetzungen in den Trägergaslinien sind zum einen so gewählt, dass an der Substratoberfläche die für das Erreichen einer bestmöglichen Kristallqualität optimale Konzentration an Wasserstoff vorliegt.

Zum anderen sorgt der jeweilige Argonanteil in den Trägergaslinien dafür, dass durch das Ausbalancieren von Impulsflüssen eine homogene Wachstumsratenverteilung am Substrat gewährleistet ist. Dabei beruht die Wirksamkeit der zusätzlichen Verwendung von Argon darauf, dass Argon schwerer ist als Stickstoff, wohingegen Wasserstoff leichter ist als Stickstoff. Somit können die Impulsflüsse bei Variation des Wasserstoffanteils durch eine entsprechende Variation des Argonflusses ausbalanciert werden.

Zusätzlich zum Zuschalten des Gruppe-III-Quellenmaterials (hier Ga) können wahlweise die entsprechenden Ausgangsstoffe für die Dotierung zugeschaltet werden.

Es wird ein modifiziertes Ausführungsbeispiel für den Aixtron HVPE-reaktor beschrieben: als Substrat 7 kann in diesem Beispiel auch ein GaN-Substrat mit einem Durchmesser zwischen 50 und 60 mm gewählt werden. Der Reaktor ist derart umgebaut, dass nicht nur in der Separationslinie, welche Ammoniak- und Galliumchloridlinie voneinander trennt, sondern auch in der äußeren Wandspüllinie ein beliebiges Gemisch aus den drei Trägergasen Wasserstoff, Argon und Stickstoff eingestellt werden kann - und zwar in jeweils unterschiedlichen Volumenstrom- bzw. Massenflussraten. Der HVPE-Prozess findet zum Beispiel bei einer Temperatur von etwa 1050°C und bei einem Druck von 800 mbar mit einem V/III-Verhältnis von etwa 35 statt.

Der Trägergasfluss in der Separationslinie (Gaseinlass 2) besteht zu 50 Vol.% aus Wasserstoff, zu 30 Vol.% aus Argon und zu 20 Vol.% aus Stickstoff. Der Trägergasfluss in der äußeren Wandspüllinie (Gaseinlass 4) setzt sich folgendermaßen zusammen: 53 Vol.% Wasserstoff und 47 Vol.% Stickstoff. Die mittlere Wachstumsrate beträgt ∼ 220pm/h und wird durch ein Schichtdickenmapping mittels Ellipsometrie bestimmt.

Die Schichtdickenverteilung wurde im Experiment durch Mappen der Oberfläche mittels eines in-situ-Ellipsometers M2000 der J.A. Woollam Co., Lincoln, Nebraska, U.S.A., bestimmt. Der Messpunktabstand betrug in zwei zueinander senkrechten Richtungen auf der Oberfläche etwa 5 mm. Dabei wurde aus jedem Spektrum durch eine Modellrechnung aus den ellipsometrischen Parameter Psi und Delta die Schichtdicke bestimmt (vgl. H.G. Tomkins et al. in "Spectroscopic Ellipsometry and Reflectometry", Wiley, new York, 1989).

Die dabei ebenfalls bestimmte Homogenität der Wachstumsratenverteilung ist durch die statistische Standardabweichung der gemessenen Schichtdicken definiert. Sie beträgt gemäß der Erfindung weniger als 10 %, in einem Beispiel sogar weniger als 7% bei Beachtung eines Randausschlussbereichs von 4 mm. Besonders erwähnenswert ist der Grad an einer simultan mit der Schichtdickehomogenität erzielten Kristallinität, welches weiter unten genauer erläutert werden soll.

Bei dem in Fig. 2 und 3 gezeigten konzentrischen, vertikalen Aufbau bestimmen die Impulse, d.h. Massen und Flussraten der aus den einzelnen Gaseinlässen austretenden Gase über das Strömungsprofil. Strömt zum Beispiel außen in der Wandspüllinie ein relativ schweres Gas wie Stickstoff und innen wie in der Separationslinie ein relativ leichtes Gas wie Wasserstoff, so wird der Stickstoff nach innen drängen, woraus letztlich ein konvexes Wachstumsratenprofil resultiert, denn in der Substratmitte erhält man die höchste Wachstumsrate. Der Erfindung zufolge ist nun vorgesehen, z.B. in der Separationslinie zusätzlich Argon oder ein anderes schweres Gas einzusetzen, um das Wachstumsprofil wieder mehr konkav zugestalten. Der Grund liegt in der größeren Masse der innen strömenden Gase.

Umgekehrt kann außen in der Wandspüllinie auch ein drittes, leichteres Gas Trägergas eingesetzt werden.

Die Wirkung des Argons erklärt sich wie folgt: durch die größere Masse des Argons im Vergleich zu Stickstoff kann in einer Wasserstofflinie durch Zugabe von Argon in eine innere Gaslinie der Impulsfluss einer äußeren Stickstoffdominierten Gaslinie kompensiert werden. Damit wird ein konstantes homogenes Wachstumsprofil erzielt.

Grundsätzlich wäre dies auch mit Variation nur des Verhältnisses von N₂ zu H₂ möglich. Jedoch ist dieses Verhältnis dadurch festgelegt ("gepinnt"), dass die H₂-Konzentration bzw. das Verhältnis zu N₂ an der Oberfläche des Substrats einen vorgegebenen Wert einnehmen sollte, um eine optimale Kristallqualität zu erhalten.

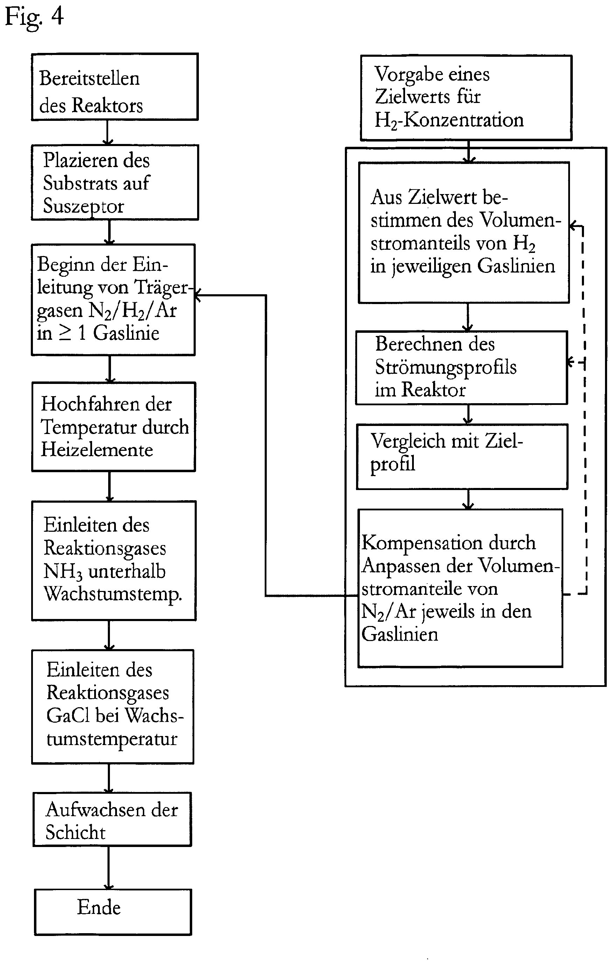

Ein beispielhafter Ablauf des erfindungsgemäßen Verfahrens ist in Figur 4 gezeigt. Der auf der linken Seite des Diagramms gezeigte Ablauf wurde im Wesentlichen bereits in den beiden obigen Ausführungsbeispielen beschrieben. Die einzelnen Schritte sind zum teil als sich zeitlich überlappende Vorgänge zu verstehen, so werden die Trägergase zwar vor den Reaktionsgasen eingeleitet, ihr Strom bleibt natürlich aber auch während der Wachstumsphase bestehen.

Auf der rechten Seite der Figur 4 ist die Bestimmung der Volumenstromanteile für die drei Trägergase schematisch dargestellt. Eine Zielkonzentration von H₂ an der Oberfläche wird vorgegeben. Daraus wird abgeleitet der Volumenstromanteil von H₂ in der oder den Gaslinien, die erforderlich ist, um die Zielkonzentration zu erreichen. Der Zusammenhang kann anhand von Simulationen der Strömungen an der Substratoberfläche berechnet werden.

Die Simulationen können auch die Bestimmung der Volumenstromanteile von N₂ und Ar zum Gegenstand haben. Vom Prinzip her ist ein Strömungsprofil als Zielwert zu erreichen. Durch Einstellen der Volumenstromanteile von N₂ und Ar (z.B. gegenüber Standardvorgaben für diese Werte), die dabei freie Parameter darstellen können, wird eine durch den berechneten von H₂-Volumenstromanteil verursachte Abweichung vom Zielprofil kompensiert. Die gestrichelten Linien in Figur 4 zeigen an, dass dazu gegebenenfalls auch ein iterativer Prozess erforderlich sein kann.

Die Bestimmung der Konzentrationen und Strömungsprofile über Experiment und Messung und die daraus erfolgte Anpassung der Volumenstromanteile ist von der Erfindung grundsätzlich eingeschlossen.

In einer Weiterbildung der Erfindung wird als Substrat ein III-N-Substrat mit einer c-, a-, m- oder r-Ebene als Wachstumsebene verwendet, und der III-N-Bulkkristall wird auf der ausgewählten Wachstumsebene abgeschieden.

In einer anderen Weiterbildung der Erfindung wird als Substrat ein III-N-Substrat mit einer Wachstumsebene, die gegenüber einer c-, a-, m- oder r-Ebene eine Verkippung von 0.1 -30° aufweist, verwendet, und der III-N-Bulkkristall wird darauf abgeschieden.

In einer weiteren Weiterbildung der Erfindung wird als Substrat ein dotiertes III-N-Substrat verwendet, auf dem ein dotierter III-N-Bulkkristall abgeschieden wird, wobei als Dotierstoffe jeweils ein Element verwendet wird, das ausgewählt wird aus der Gruppe, die aus Silizium, Tellur, Magnesium und Eisen besteht. Ferner kann der Erfindung zufolge als Substrat einkristallines Saphir, Siliziumkarbid, Galliumarsenid, Lithiumaluminat oder Silizium verwendet, und darauf wird ein III-N-Bulkkristall abgeschieden werden. In einer besonderes bevorzugten Ausführungsform wird als Substrat ein GaN-Substrat in freistehender Form oder in Template-Form verwendet, und ein GaN-Bulkkristall wird erfindungsgemäß gezüchtet.

Nachdem das erfindungsgemäße Verfahren durchgeführt wurde, können freistehende III-N-Kristallsubstrate in einfacher Weise hergestellt werden, indem ein oder mehrere III-N-Substrate von dem III-N-Bulkkristall abgetrennt werden. Eine besonders geeignete Methode der Abtrennung ist das Drahtsägen. Anschließend können weitere Bearbeitungsschritte folgen, insbesondere zum Beispiel Läppen, Polieren, thermisches Nachbehandeln und/oder beliebige Endreinigungsschritte.

Bei der Erfindung kann ferner vorgesehen sein, einen III-N-Bulkkristall bereitzustellen, der nach dem erfindungsgemäßen Verfahren erhältlich ist. Vorzugsweise ist er nach dem erfindungsgemäßen Verfahren gemäß den beigefügten Ansprüchen oder wie in den Ausführungsbeispielen angegeben hergestellt. Mit dem Bulkristall übernimmt auch der aus Vereinzelung, etwa durch Draht- oder Innenlochsägen daraus erhaltene Einkristall die hervorragenden Eigenschaften hinsichtlich Kristallinität und Schichtdickenhomogenität.

Ein solchermaßen hergestellter III-N-Kristall überrascht durch seine einzigartig gute Kristallinität. Dies gilt dann natürlich auch für die entsprechend daraus abgetrennten, vereinzelten und freistehenden III-N-Substrate. Besonders hervorzuheben ist der Effekt, dass die Kristallinität gleichzeitig und in Kombination mit einer hohen Schichtdickenhomogenität erreicht wird. Wie oben zum Ausführungsbeispiel beschrieben beträgt die Schichtdickenhomogenität gemäß der Erfindung weniger als 10 %, in einem Beispiel sogar weniger als 7% bei Beachtung eines Randausschlussbereichs von 4 mm.

Die Kristallinität des Kristalls lässt sich insbesondere durch Rockingkurven-Mapping und/oder durch Mikro-Raman-Mapping definieren.

Messtechnisch werden dabei beispielsweise mittels Röntgenbeugung die räumliche Verteilung der Absolutlagen oder die Halbwertsbreiten von Röntgenbeugungskurven entsprechend der Beugung an bestimmten Netzebenenscharen erfasst. Die Homogenität der Kristallqualität (Kristallinität) in der Wachstumsebene kann beim Rockingkurven-Mapping durch Aufnehmen von ω-Scans an verschiedenen Probenstellen überprüft werden. Der ω-Scan wird in einer Ebene parallel zur Wachstumsebene aufgenommen. Im Falle eines Wachstums in [0001]-Richtung kann bei den ω-Scans die Reflexion der (0002)-Netzebenen genutzt werden.

Die Homogenität der Kristallqualität in Wachstumsrichtung kann dagegen mittels der Standardabweichung der Mittelwerte der Halbwertsbreiten der (0002) ω-Scans einzelner Substrate, die aus dem entsprechenden III-N-Bulkkristall gewonnen wurden, bestimmt werden.

Alternativ kann die Homogenität der Kristallqualität in Wachstumsrichtung durch das Rockingkurven-Mapping bestimmt werden, das in einer Ebene, die die Wachstumsrichtung enthält, aufgenommen wurde. Beim Wachstum in [0001]-Richtung kann dann bei den Ω-Scans beispielsweise die Reflexion an einer m-Ebene ausgewählt aus {1̅100} bzw. {(101̅0),(011̅0),(1̅100),(1̅010),(01̅10),(11̅00)} genutzt werden. Das Mapping wird auf einer entsprechenden m-Fläche bzw. einer gegenüber der entsprechenden m-Ebene leicht verkippten Fläche mit einem Verkippungswinkel zwischen 0-10° ausgeführt.

Eine zweite Methode zur Bestimmung der Homogenität der Kristallqualität sind Mikro-Raman-Mappings. So sind beispielsweise die Standardabweichungen von Frequenz und Halbwertsbreite des E₂-Phonons bei einem Scan auf einer Fläche parallel zur Wachstumsebene bzw. in Wachstumsrichtung Maße für die Homogenität der Kristallqualität in den entsprechenden Richtungen. Die Homogenität der Kristallqualität des Bulkkristalls in Wachstumsrichtung kann wiederum vorzugsweise an Hand der Standardabweichung der Mittelwerte der Halbwertsbreiten des E₂-Phonons der einzelnen Substrate, die aus dem entsprechenden Bulkkristall gewonnen wurden, bestimmt werden.

Folgende Ergebnisse wurden vorliegend für einen erfindungsgemäß gezüchteten Kristall erhalten:
Bei einem Rockingkurven-Mapping des erfindungsgemäßen III-N-Bulkkristalls auf einer Fläche parallel zur Wachstumsebene beträgt die Standardabweichung der jeweils gemessenen Halbwertsbreiten 5% oder weniger, vorzugsweise 3% oder weniger. Auf einer Fläche in Wachstumsrichtung beträgt die Halbwertsbreite 10% oder weniger, vorzugsweise 7,5%, besonders bevorzugt 5% oder weniger.

Die Standardabweichung konnte ermittelt werden, indem bei einer Vielzahl, z.B. bei 100 Messpunkten, der zu messenden Flächen jeweils Messungen zum Rockingkurven-Mapping durchgeführt werden, von allen Messungen der Mittelwert der Halbwertsbreiten gebildet wird und gegenüber diesem Mittelwert über eine übliche statistische Auswertung die Standardabweichung ermittelt wird.

Alternativ konnte die Kristallinität auch über ein Mikro-Raman-Mapping des III-N-Bulkkristalls auf einer Fläche parallel zur Wachstumsebene und/oder in Wachstumsrichtung bestimmt werden. Angegeben wird die Standardabweichung der gemessenen Halbwertsbreiten des E₂-Phonons. Im ersten Fall (Fläche parallel zur Wachstumsebene) beträgt sie 5% oder weniger, vorzugsweise 3% oder weniger, weiter bevorzugt 2% oder weniger. Im zweiten Fall beträgt die Standardabweichung 10% oder weniger, vorzugsweise 7,5% oder weniger, weiter bevorzugt 5% oder weniger. Die Messung erfolgt analog zu derjenigen des Rocking-Kurven-Mappings über z.B. 100 Messpunkte.

Die angegebenen Werte zur Kristallinität gelten insbesondere auch für erhaltene GaN-Kristalle. Nochmals zu betonen ist die Kombination dieser hervorragenden Werte zur Kristallinität mit jenen der Schichtdickenhomogenität, die erfindungsgemäß erzielt werden kann.

## Patentansprüche

1. Verfahren zum Herstellen eines Verbindungs-Halbleiterwerkstoffs mittels Gasphasenepitaxie in einem Reaktor, (10, 20) bei dem in einem Gemisch von Trägergasen, das ein oder mehrere Reaktionsgase in Richtung auf ein Substrat (7, 16) mitführen kann, ein durch lokale Massenflussraten repräsentiertes Strömungsprofil in dem Reaktor ausgebildet wird,
**dadurch gekennzeichnet, dass**
ein vorbestimmter Wert für die Konzentration von Wasserstoff an der Oberfläche des Substrats (7, 16) durch Einstellen eines Volumenstromanteils eines ersten Trägergases in dem Gemisch erreicht wird, und
der dadurch entstehende Einfluss auf das Strömungsprofil im Reaktor (10, 20) durch Anpassen der jeweiligen Volumenstromanteile eines zweiten sowie eines dritten Trägergases in dem Gemisch kompensiert wird, um ein vorbestimmtes, von der Wasserstoffkonzentration unabhängiges Strömungsprofil zu erhalten.

2. Verfahren nach Anspruch 1, **dadurch gekennzeichnet, dass**:
der Reaktor (10, 20) wenigstens eine erste Gaslinie (1,2,3, 4; 23, 23') aufweist, in die das wenigstens drei Trägergase umfassende Gemisch eingeleitet wird, durch deren Volumenstromanteil und spezifisches Gasgewicht jeweils das Strömungsprofil gesteuert wird, wobei das zweite Trägergas Stickstoff ist und für das dritte Trägergas ein solches Gas mit einem spezifischen Gasgewicht, das verschieden von demjenigen des Stickstoffs ist, ausgewählt wird, und/oder
das ausgewählte dritte Trägergas ein Edelgas, insbesondere Argon, Helium, Neon oder Krypton ist, und/oder
in das Gemisch Wasserstoff als erstes Trägergas eingeleitet wird.

3. Verfahren nach einem der Ansprüche 1 oder 2, bei dem die Gaslinie, in die das dritte Trägergas eingeleitet wird, eine Separationslinie (2) ist, die zwei Gaslinien (1, 3) voneinander trennt, welche Reaktionsgase mit sich führen.

4. Verfahren nach Anspruch 3, bei dem
der Reaktor eine weitere Gaslinie (4) als Wandspüllinie an einer Außenwand (5) aufweist, in die ein Gemisch des ersten und zweiten Trägergases mit jeweiligen Volumenstromanteilen eingeleitet wird, und
der Volumenstromanteil des dritten Trägergases in der Separationslinie (2) in Abhängigkeit von den Volumenstromanteilen der ersten und zweiten Trägergase in der weiteren Gaslinie (4) an der Außenwand (5) des Reaktors (10) gewählt wird.

5. Verfahren nach einem der vorhergehenden Ansprüche, **dadurch gekennzeichnet, dass** der herzustellende Verbindungs-Halbleiterwerkstoff ein III-N-Kristall, insbesondere eine III-N-Schicht auf Fremdsubstrat oder ein III-N-Bulksubstrat ist, und/oder
der herzustellende III-N-Kristall Galliumnitrid umfasst, wobei das Galliumnitrid aufgrund einer Reaktion der eingeleiteten Reaktionsgase mit anschließender Abscheidung auf dem Substrat (7, 16) im Reaktor (10, 20) einkristallin gebildet wird, und/oder
als Substrat eines aus: Saphir, Silizium, Siliziumcarbide, Diamant, Lithiumgallate, Lithiumaluminate, Zinkoxide, Spinelle, Magnesiumoxide, ScAlMgO₄, GaAs, GaN, AlN, InN, AlGaN oder InGaN eingesetzt wird.

6. III-N-Bulkkristall, insbesondere aus Galliumnitrid, welcher eine Schichtdickenhomogenität mit einer Standardabweichung von 7 % oder weniger - bezogen auf die Schichtdicke und unter Ausschluss eines Substratrands von 4 mm - aufweist,
wobei bei einem Rockingkurvenmapping auf einer Fläche
(i) parallel zur Wachstumsebene und/oder
(ii) in Wachstumsrichtung
die Standardabweichung der jeweils gemessenen Halbwertsbreiten im Fall (i) 3% oder weniger, im Fall (ii) 5% oder weniger beträgt.

7. III-N-Bulkkristall nach Anspruch 6, welcher ferner im Kristall aufgenommene Bestandteile eines Edelgases, insbesondere von Argon, Krypton, Neon oder Helium, aufweist, und/oder
wobei bei einem Mikro-Ramanmapping auf einer Fläche
(i) parallel zur Wachstumsebene und/oder
(ii) in Wachstumsrichtung
die Standardabweichung der gemessenen Halbwertsbreiten des E₂-Phonons im Fall (i) 3% oder weniger, und im Fall (ii) 5% oder weniger beträgt.

8. III-N-Einkristall, erhältlich durch Vereinzelung, insbesondere durch Zersägen, des III-N-Bulkkristalls nach einem der Ansprüche 6-7.

## Claims

1. Method for manufacturing a semiconductor compound material by means of a vapour phase epitaxy in a reactor (10, 20), wherein in a mixture of carrier gases, which is arranged to carry one or more reaction gases in a direction towards a substrate (7, 16), a flow profile represented by local mass flow rates is formed in the reactor,
**characterized in that**
a predetermined value for the concentration of hydrogen at the surface of the substrate (7, 16) is obtained by adjusting a volume flow proportion of a first carrier gas in the mixture, and
the influence exerted on the flow profile in the reactor (10, 20) arising thereby is compensated by adjusting corresponding volume flow proportions of a second and a third carrier gas in the mixture, in order to obtain a predetermined flow profile independent from the hydrogen concentration.

2. Method according to claim 1, **characterized in that**
the reactor (10, 20) comprises at least one first gas line (1, 2, 3, 4; 23, 23'), into which the mixture composed of the at least three carrier gases is introduced, the volume flow proportion and the specific gas weight of which controlling the flow profile,
wherein the second carrier gas is nitrogen, and for the third carrier gas, a gas having a specific gas weight being different from that of nitrogen is selected, and/or
the third carrier gas selected is a noble gas, particularly argon, helium, neon or krypton, and/or
hydrogen is introduced into the mixture as the first carrier gas.

3. Method according to any one of claims 1 or 2, wherein the gas line, into which the third carrier gas is introduced, is a separation line (2), which separates two gas lines (1, 3) from each other, which carry reaction gases.

4. Method according to claim 3, wherein
the reactor comprises a further gas line (4) as a wall purge line at an outer peripheral wall (5), into which a mixture of the first and the second carrier gases with corresponding volume flow proportions is introduced, and
the volume flow proportion of the third carrier gas in the separation line (2) is selected in dependence of the volume flow proportions of the first and second carrier gases in the further gas line (4) at the outer peripheral wall (5)of the reactor (10).

5. Method according to any one of the preceding claims, **characterized in that** the semiconductor compound material to be manufactured is a III-N-crystal, particularly a III-N-layer formed on a remote substrate, or a III-N-bulk substrate, and/or
the III-N-crystal to be manufactured comprises gallium nitride, wherein the gallium nitride is formed by a reaction of the introduced reaction gases with subsequent deposition onto the substrate (7, 16) in the reactor (10, 20) in single crystalline manner, and/or
as a substrate one of the group comprising: sapphire, silicon, silicon carbide, diamond, lithium gallate, lithium aluminate, zinc oxide, spinel, magnesium oxide, ScAlMgO₄, GaAs, GaN, AlN, InN, AlGaN or InGaN, is employed.

6. III-N-bulk crystal, particularly formed of gallium nitride, which has a thickness layer homogeneity with a standard deviation of 7 % or less - with concern to the layer thickness and an exclusion from the substrate edge of 4 mm,
wherein in a rocking curve-mapping of an area
(i) parallel to the growth plane and/or
(ii) in growth direction
the standard deviation of full-width half-mean measured amounts to 3% or less in case (i) or 5% or less in case (ii).

7. III-N-bulk crystal according to claim 6, which further comprises constituents of a noble gas absorbed within the crystal, particularly argon, krypton, neon or helium, and/or
wherein in a micro-Raman-mapping of an area
(i) parallel to the growth plane and/or
(ii) along growth direction
the standard deviation of the full-width half-mean being measured of the E₂-phonon amounts to 3% or less in case (i), or 5% or less in case (ii).

8. III-N-single crystal, obtained by separation, particularly by sawing, of the III-N-bulk crystal according to one of claims 6 to 7.

## Revendications

1. Procédé de fabrication d'un matériau semi-conducteur de liaison au moyen d'une épitaxie en phase vapeur dans un réacteur (10, 20) dans lequel dans un mélange de gaz porteurs, qui peut entraîner un ou plusieurs gaz réactionnels en direction d'un substrat (7,16), un profil d'écoulement représenté par des débits massiques locaux est formé dans le réacteur,
**caractérisé en ce**
**qu'**une valeur prédéterminée pour la concentration d'hydrogène à la surface du substrat (7, 16) est atteinte par réglage d'une proportion de courant volumique d'un premier gaz porteur dans le mélange, et
**que** l'effet ainsi créé sur le profil d'écoulement dans le réacteur (10, 20) est compensé par un ajustement des proportions de courant volumique respectives d'un deuxième ainsi que d'un troisième gaz porteur dans le mélange, pour obtenir un profil d'écoulement prédéterminé, indépendant de la concentration d'hydrogène.

2. Procédé selon la revendication 1, **caractérisé en ce que** :
le réacteur (10, 20) présente au moins une première ligne de gaz (1, 2, 3, 4 ; 23, 23') dans laquelle le mélange comprenant au moins trois gaz porteurs est introduit, le profil d'écoulement étant commandé respectivement par le biais de leur proportion de courant volumique et poids de gaz spécifique, dans lequel le deuxième gaz porteur est de l'azote et pour le troisième gaz porteur, on choisit un gaz tel qu'il ait un poids de gaz spécifique qui est différent de celui de l'azote, et/ou
le troisième gaz porteur choisi est un gaz rare, en particulier, de l'argon, de l'hélium, du néon ou du crypton, et/ou
dans le mélange, de l'hydrogène est introduit comme premier gaz porteur.

3. Procédé selon l'une quelconque des revendications 1 ou 2, dans lequel la ligne de gaz dans laquelle le troisième gaz porteur est introduit, est une ligne de séparation (2) qui sépare l'une de l'autre deux lignes de gaz (1, 3) qui transportent des gaz réactionnels.

4. Procédé selon la revendication 3, dans lequel
le réacteur présente une autre ligne de gaz (4) comme ligne de rinçage de paroi au niveau d'une paroi extérieure (5), dans laquelle un mélange du premier et du deuxième gaz porteur avec des proportions de courant volumique respectives est introduit, et
la proportion de courant volumique du troisième gaz porteur dans la ligne de séparation (2) est choisie en fonction des proportions de courant volumique du premier et du deuxième gaz porteur dans l'autre ligne de gaz (4) au niveau de la paroi extérieure (5) du réacteur (10).

5. Procédé selon l'une quelconque des revendications précédentes, **caractérisé en ce que** le matériau semi-conducteur de liaison à produire est un cristal III-N, en particulier une couche III-N sur un substrat étranger ou un substrat en vrac III-N, et/ou
le cristal III-N à produire est un nitrure de gallium, dans lequel le nitrure de gallium est formé dans le réacteur (10, 20) de façon monocristalline en raison d'une réaction des gaz réactionnels introduits avec dépôt consécutif sur le substrat (7, 16), et/ou
est utilisé comme substrat de l'un parmi : saphir, silicium, carbure de silicium, diamant, gallate de lithium, aluminate de lithium, oxyde de zinc, spinelle, oxyde de magnésium, ScAlMgO₄, GaAs, GaN, AlN, InN, AlGaN ou InGaN.

6. Cristal en vrac III-N, en particulier issu de nitrure de gallium, qui présente une homogénéité d'épaisseurs de couche ayant un écart type de 7 % ou inférieur, par rapport à l'épaisseur de couche et à l'exclusion d'un bord de substrat de 4 mm,
dans lequel lors d'une cartographie des courbes de basculement sur une surface
(i) parallèle au plan de croissance et/ou
(ii) dans la direction de croissance
l'écart type des demi-largeurs mesurées respectives dans le cas (i) est de 3 % ou inférieur, dans le cas (ii) est de 5 % ou inférieur.

7. Cristal en vrac III-N selon la revendication 6, qui présente en outre des composants d'un gaz rare absorbés dans le cristal, en particulier d'argon, de crypton, de néon ou d'hélium, et/ou
dans lequel lors d'une micro-cartographie Raman sur une surface
(i) parallèle au plan de croissance et/ou
(ii) dans la direction de croissance
l'écart type des demi-largeurs mesurées du phonon E₂ dans le cas (i) est de 3 % ou inférieur, dans le cas (ii) est de 5 % ou inférieur.

8. Monocristal III-N, pouvant être obtenu par séparation, en particulier par sciage du cristal en vrac III-N selon l'une quelconque des revendications 6 à 7.
